# EUROPEAN PATENT SPECIFICATION

(11) **EP 1 654 804 B1**
(45) Date of publication and mention of the grant of the patent: **17.01.2007**
(21) Application number: 04744648.9
(22) Date of filing: 27.07.2004
(51) Int. Cl.: H03K 17/0412

(54) **HIGH FREQUENCY CONTROL OF A SEMICONDUCTOR SWITCH**
HOCHFREQUENZREGELUNG EINES HALBLEITER-SCHALTERS
COMMANDE DE HAUTE FREQUENCE D'UN COMMUTATEUR SEMI-CONDUCTEUR

(30) Priority: 01.08.2003 EP 03102399
(43) Date of publication of application: 10.05.2006
(73) Proprietor: Philips Intellectual Property & Standards GmbH, 20099 Hamburg (DE); Koninklijke Philips Electronics N.V., 5621 BA Eindhoven (NL)
(72) Inventor: TOLLE, Tobias, Georg, Philips IP & Standards GmbH, 52066 Aachen (DE); DÜRBAUM, Thomas c/o Philips IP & Standards GmbH, 52066 Aachen (DE); SAUERLÄNDER, Georg, Philips IP & Standards GmbH, 52066 Aachen (DE); LOPEZ, Toni c/o Philips IP & Standards GmbH, 52066 Aachen (DE)
(74) Representative: Volmer, Georg
(86) International application number: PCT/IB2004/051294
(87) International publication number: WO 2005/013487

(56) References cited:
- EP-A- 0 568 279
- US-A- 4 967 109
- "RECOVERING ENERGY FROM A RAPIDLY SWITCHED GATE" NTIS TECH NOTES, US DEPARTMENT OF COMMERCE. SPRINGFIELD, VA, US, 1 December 1990 (1990-12-01), page 1046, XP000179947 ISSN: 0889-8464
- MAKSIMOVIC D ED - INSTITUTE OF ELECTRICAL AND ELECTRONICS ENGINEERS: "A MOS gate drive with resonant transitions" PROCEEDINGS OF THE ANNUAL POWER ELECTRONICS SPECIALISTS CONFERENCE. MASSACHUSETTS, 25 - 27 JUNE, 1991, NEW YORK, IEEE, US, vol. CONF. 22, 24 June 1991 (1991-06-24), pages 527-532, XP010048340 ISBN: 0-7803-0090-4 cited in the application

## Description

The present invention relates to the control of a semiconductor switch, and, more specifically, to an improved operation of a resonant driver circuit for a semiconductor switch. In particular, the present invention relates to a method of operating a resonant driver circuit for driving a semiconductor switch and to a control circuit for operating a resonant driver circuit for driving a semiconductor switch.

It is known in the prior art of power converters that the kind of gate drive circuit coupled to the power MOSFET switches has a crucial influence on the efficiency of the power converter, especially at high frequencies. Thus, various driver schemes have been developed. Document US 4,967,109 discloses a resonant gate driver scheme for a high frequency converter. The gate drive power loss is proportional to the switching frequency and is a major limitation in the design of high efficient power converters in the MHz region. One approach to improve the gate drive power loss is to use a resonant gate circuit as described in a paper entitled "A MOS gate drive with resonant transitions," by D. Maksimovic, 22nd Annual IEEE power electronics specialists conference (PESC), June 23 to 27, 1991, page 523 to 527. This paper describes a gate drive that provides quasi-square wave gate-to-source voltage with low impedance between gate and source terminals in both on and off states. The equivalent gate capacitance of the power MOS transistor is charged and discharged in a resonance circuit, so that energy stored in the equivalent gate capacitance is returned to the power source of the driver.

Such resonant gate drive circuits may, for example, be used in power electronics with MOSFETs that work with high switching frequencies. Thus, they may, for example, be used in switch mode power supplies (SMPS). Also, they may be adapted for applications with special requirements relating to the size, flatness, EMI or dynamics, such as voltage regulator modules (VRMs) for data processors (MPS), for flat displays and SMPS for audio sets with AM/FM tuner.

At high switching frequencies in the MHz region or higher, a both efficient and fast driving of the MOSFETs becomes more and more important. Efficient driving is necessary to reduce gate driver losses. Fast driving is necessary to keep switching losses of the power transistor inside of acceptable limits.

To achieve efficient driving, the application of resonant drivers, which are more efficient than, for example, hard switching drivers, is becoming more and more desirable. However, known resonant drivers do not achieve the same switching speed and thus are often not suitable for applications that have switching frequencies in the MHz region or higher.

It is an object of the present invention to provide for an improved operation of a resonant driver circuit for driving a semiconductor switch.

According to an exemplary embodiment of the present invention, the above object may be solved by a method, as set forth in claim 1, of operating a resonant driver circuit for driving a semiconductor switch. According to this exemplary embodiment of the present invention, the driver circuit includes a first switch for connecting a power supply via an inductor to a control terminal of the semiconductor switch and a second switch connected to the control terminal of the semiconductor switch for controlling a switching of the semiconductor switch. According to an aspect of this exemplary embodiment of the present invention, the inductor is pre-charged before a switching of the second switch.

Advantageously, due to the pre-charging of the inductor, a higher initial current may be applied to the control terminal of the semiconductor switch, thus, advantageously, both a fast and efficient switching of the semiconductor switch may be provided.

This improved operation combines both the efficient and the fast driving which are necessary for applications which have switching frequencies in the MHz region or higher.

According to an exemplary embodiment of the present invention as set forth in claim 2, an inductor current is built up previous to the switching of the second switch.

According to another exemplary embodiment of the present invention as set forth in claim 3, the inductor current before switching the second switch and thus the pre-charging of the inductor is realized by providing a time period before the switching of the second switch, during which the first switch and the second switch are switched on.

Claims 4 to 7 provide for further exemplary embodiments of the present invention. In particular, according to the exemplary embodiment of the present invention as set forth in claim 6, a method according to an exemplary embodiment of the present invention is applied to a resonant driver circuit comprising four switches and having a simple and robust set-up.

According to another exemplary embodiment of the present invention as set forth in claim 8, a control circuit is provided for operating a resonant drive circuit for driving a semiconductor switch. The control circuit according to this exemplary embodiment of the present invention comprises a switch controller for controlling the switching of the first and second switches, such that the inductor is pre-charged before a switching of the second switch.

Advantageously, this control circuit may be applied to known resonant gate driver circuits and allows for a fast and efficient operation of the semiconductor switch at high frequencies.

Claim 9 provides for an exemplary embodiment of the control circuit according to the present invention.

It may be seen as the gist of an exemplary embodiment of the present invention that the inductor of the resonant driver circuit is pre-charged before a switch controlling the switching of the semiconductor switch (such as a MOSFET) performs a switching. Due to this, an inductor current is built up, previous to the switching action, causing that an initial current charges the gate of the MOSFETs and thus allows for a faster switching of the MOSFET. According to an aspect of the present invention, the pre-charging may be performed by providing a time period, where a first switch connecting a power supply via the inductor to the gate and a second switch connected to the gate of the MOSFET for controlling a switching of the MOSFET are switched on.

Advantageously, this may provide for a fast and efficient, i.e. power efficient operation of the MOSFET, allowing that such circuits may be applied to VRMs for data processors, SMPS for flat displays or SMPS for audio sets.

These and other aspects of the present invention will become apparent from and elucidated with reference to the embodiments described hereinafter.

Exemplary embodiments of the present invention will be described in the following, with reference to the following drawings:
Fig. 1 shows a simplified circuit diagram of a resonant gate driver circuit for driving a MOSFET.
Fig. 2 shows timing charts for explaining an operation of a resonant gate driver circuit.
Fig. 3 shows timing charts of an exemplary embodiment of a method of operating a resonant gate driver circuit according to the present invention.

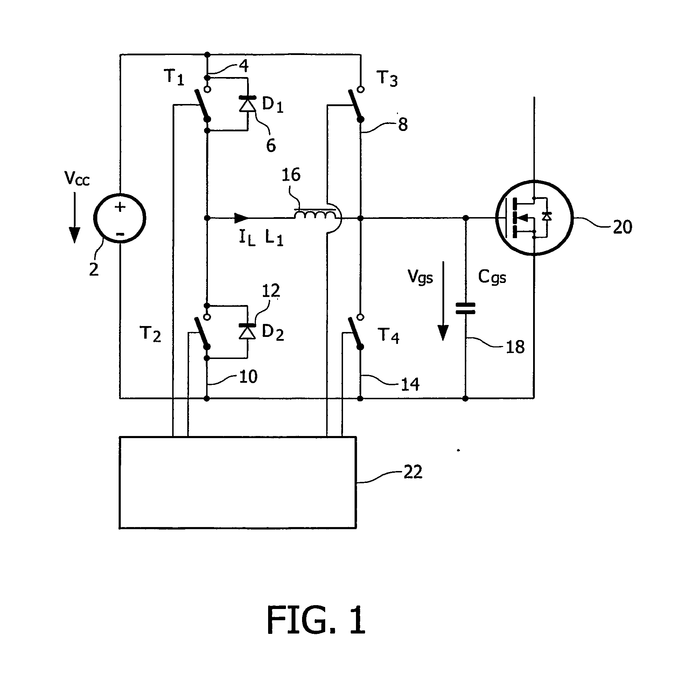

Fig. 1 shows a circuit diagram of a resonant gate driver for driving a MOSFET 20, such as a power MOSFET, including a control circuit for operating the resonant gate driver circuit according to an exemplary embodiment of the present invention.

Reference numeral 2 in Fig. 1 designates a power supply generating a power supply voltage V_{CC}. Reference numeral 4 designates a first switch T₁ connected between the power supply voltage V_{CC} and a first end of an inductor 16. Reference numeral 6 designates a diode D₁. Reference numeral 10 designates a second switch T₂ connected between ground and the first end of the inductor L₁ 16. Parallel to the switch T₂ 10 between ground and the first end of the inductor L₁ 16 there is provided another diode D₂ 12. D₁ can be the intrinsic body diode of T₁ when T₁ is a MOSFET switch. D₂ can be the intrinsic body diode of T₂ when T₂ is a MOSFET switch. I_{L} is the current flowing into the inductor L₁ 16.

Reference numeral 8 designates a third switch T₃ provided between the power supply voltage V_{CC} and a second end of the inductor L₁ 16. The second end of the inductor L₁ 16 is also connected to a gate of the MOSFET 20. Reference numeral 14 designates a fourth switch T₄ provided between the second end of the inductor L₁ 16 and ground. Between the second end of the inductor L₁ 16, i.e. the gate of the MOSFET 20 and ground, parallel to the fourth switch T₄14, there is drawn a capacitance C_{GS} 18. This may either be just the representation of the equivalent gate capacitance of the MOSFET 20, or it may be the sum of an external capacitance plus the representation of the equivalent gate capacitance of the MOSFET 20. A voltage across the capacitance C_{GS} 18 is referred to as V_{GS}.

Furthermore, according to an aspect of the present invention, there is provided a control circuit 22 for operating the switching of the first to fourth switches 4, 8, 10 and 14. The first to fourth switches T₁ to T₄ (reference numerals 4, 8, 10 and 14). These may also be enhancement mode metal oxide semi-conductor field effect transistors (MOSFETs). However, it is also possible to, for example, to provide CMOS switches or other suitable switches. The control circuit may, for example, be realized by means of a state machine or EPLD, such as the ones manufactured by Alterra ® and maybe suitable switch drivers between the control circuit 22 and the respective one of the switches T₁ to T₄.

A drive signal provided from the control circuit 2 to the switches T₁ to T₄ may have a frequency extending from hundreds of KHz to the MHz range. The capacitance C_{GS} 18 may, depending on the frequency range where the circuit is operated, be in the range of 0,5 to 10nF and the inductor L₁ 16 may have an inductance of 50-1000nH( ( e.g. 200nH for Cgs=2nF and 1MHz).

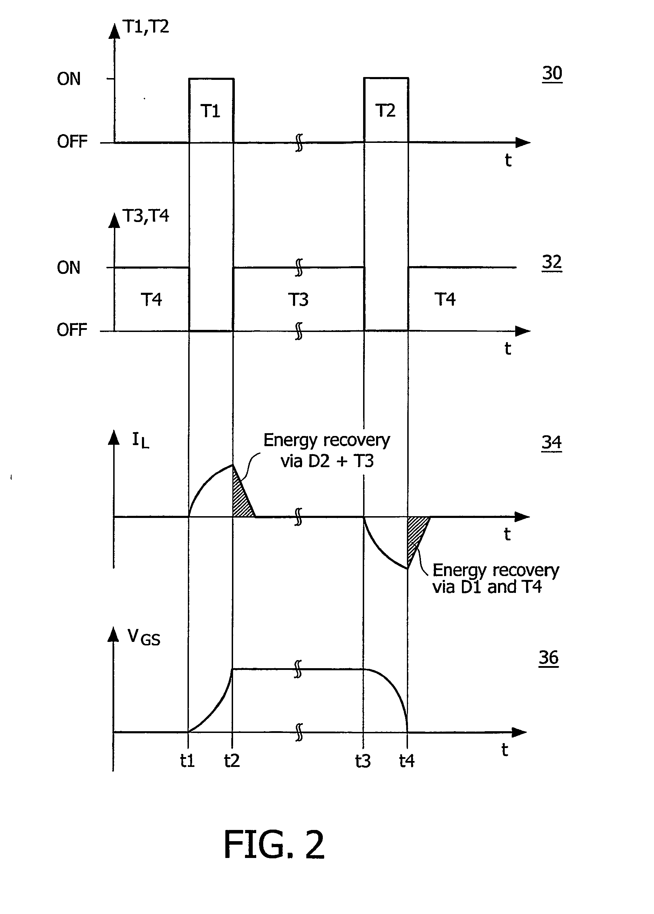

In the following, with reference to the timing charts of Fig. 2, an exemplary operation of the resonant gate driver circuit depicted in Fig. 1 will be described.

Timing chart 30 of Fig. 2 shows the switching of the first and second switches T1 and T2 over the time. The timing chart 32 of Fig. 2 shows the switching of the third and fourth switches T3 and T4 over the time. The timing chart 34 shows the corresponding I_{L} over the time and the timing chart 36 shows the voltage V_{GS} over the time.

As may be taken from Fig. 2, when the MOSFET 20 is to be switched on, the fourth switch T₄ switches off and at the same point in time t₁, the first switch T₁ switches on and connects the gate of the MOSFET 20 to V_{CC} via the inductor L₁ 16. V_{cc} is provided by the power supply 2. This causes an increase of the inductor current I_{L} as shown in timing chart 34 until t₂ where the first switch T₁ is switched off and the third switch T₃ is switched on. At t₂, the inductor current I_{L} reaches its positive peak. At the same time t₂, the voltage V_{GS} reaches its desired value and the MOSFET 20 is fully switched on. After t₂, the energy recovery takes place via the diode D₂ and the third switch T₃, causing an almost linear decrease of the inductor voltage I_{L}. In practical applications, a diode parallel to T₃ can reduce the risk of over-voltage at the Vgs, which could result from improper timing. This over-voltage would reduce the efficiency of the converter and could sometimes even be destructive. This diode can be the intrinsic body diode of T₃ in case that T₃ is for example a MOSFET.

Thus, as may be taken from Fig. 2, it requires the time period [t₁; t₂] until the full gate voltage of the MOSFET 20 is reached and the switching of the MOSFET 20 is complete. Thus, the inductor L₁, as may be taken from the timing chart 34, showing the inductor current I_{L}, slows the charge flow into the gate of the MOSFET 20 and therewith the rise of the gate voltage V_{GS} and thus the switching of the MOSFET 20.

At t₃, the third switch T₃ is switched off and the second switch T₂ is switched on. This causes an increase of the inductor current I_{L}, this time flowing in the direction opposite that during [t₁; t₂]. Due to this, from t₃ on the gate voltage V_{GS} decreases until it reaches zero at t₄, where the inductor current I_{L} reaches its peak and the second switch T₂ is switched off and the fourth switch T₄ is switched on. In practical applications, a diode parallel to T₄ can reduce the risk of negative over-voltage at the Vgs, which could result from improper timing. This over-voltage would reduce the efficiency of the converter and could sometimes even be destructive. This diode can be the intrinsic body diode of T₄ in case that T₄ is for example a MOSFET.

Thus, as may be taken from Fig. 2, it takes the time period between [t3; t4] until the gate voltage V_{GS} reaches zero and accordingly a relatively long time until the MOSFET 20 is switched off. Thus, in spite of the fact that such an operation is very loss efficient, it does not allow for the operation at high frequency, since the inductor L₁ slows down the rise and fall of the gate voltage V_{GS}.

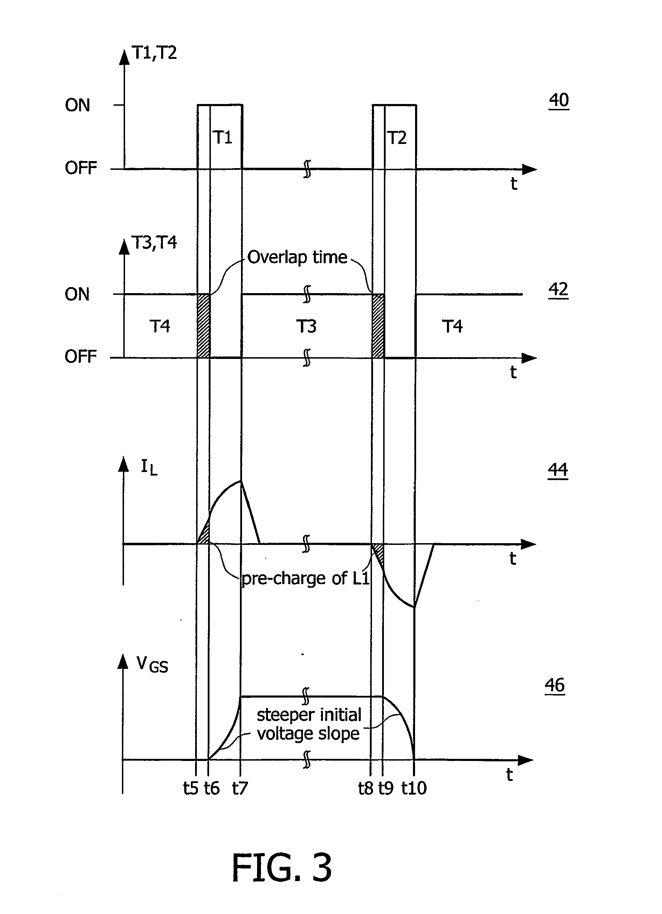

Fig. 3 shows a method of operating the resonant gate driver circuit according to the present invention, which, as indicated above, may be implemented with the control circuit 22 according to an exemplary embodiment of the present invention, controlling the first to fourth switches T₁ to T₄ to perform a switching as indicated in the timing charts 40 to 46 of Fig. 3. As indicated above, the control circuit may be implemented as a state machine or EPLD with suitable drivers to operate the first to fourth switches T₁ to T₄, as a digital circuit including amplifiers for driving the respective first to fourth switches T₁ to T₄ or may be realized as a suitable analogue circuit.

Timing chart 40 shows the switching of the first and second switches T₁ and T₂ over the time and timing chart 42 shows the switching of the third and fourth switches T₃ and T₄ over the time. The third timing chart 44 shows the inductor current I_{L} over the time and the fourth timing chart 46 shows the gate voltage across the capacitor C_{GS} 18 over the time.

As may be taken from Fig. 3, the first switch T₁ is switched on at t₅ before the fourth switch T₄ is switched off at t₆. This provides for an overlap time period, where both the first switch T₁ and the fourth switch T₄ are switched on. This causes a pre-charging of the inductor L₁16 as shown by I_{L} in the timing chart 44. In other words, before the fourth switch T₄ is switched off, controlling the switching of the MOSFET 20, the first switch T₁ is switched on, causing a pre-charging of the inductor L₁16. This pre-charging is realized by building up an inductor current during [t₅; t₆] before the actual switching of the MOSFET 20, which follows at t₆ by shutting the fourth transistor T4 off.

In other words, the pre-charging of the inductor L₁ 16 is performed by providing an overlap time period, during which the first switch T₁ and the fourth switch T₄ are switched on.

Then, after the switching of the fourth switch T₄ at t₆, the inductor current I_{L} increases up to its peak at t₇, where the first switch T₁ is shut off and the gate voltage V_{gs} reaches its desired level.

As a comparison of [t₁; t₂] to [t₆; t₇] shows, the time period [t_{6;} t₇] is significantly shorter than the time period [t₁; t₂]. Thus, according to the exemplary embodiment of the present invention shown in Fig. 3, the actual switching time required for switching the MOSFET 20 can be reduced significantly. As described above, this is done by providing an overlap time of the first switch T₁ and the fourth switch T₄. Due to this, the inductor current I_{L} is built up, starting at t₅ previous to the switching action at t₆. Due to this, in comparison to Fig. 2, a much higher initial current charges the gate, which allows for a much faster charging of the gate capacitance C_{gs}18.

Advantageously, by performing the switching operation as described with reference to Fig. 3, a very efficient switching may be performed,-even at high switching frequencies. Also, as a comparison of V_{GS} of a timing chart 36 in Fig. 2 to the timing chart 46 in Fig. 3 shows, the voltage slope between t₆ and t₇ is significantly steeper than the voltage slope between t₁ and t₂.

At t₈, the second switch T₂ is switched on before the third switch T₃ is switched off at t₉. This provides for an overlap time period from t₈ to t₉, where the second transistor T₂ connecting the gate of the MOSFET 20 via the inductor L₁ 16 to ground (- of the power supply 2) and the third switch T₃ controlling the switching of the MOSFET 20 being connected to the gate of the MOSFET 20, are switched on. By this, the inductor L₁ 16 is pre-charged by building up the inductor current I_{L}. Then, at t₉, the third transistor T3 is switched off. This causes a sharp decrease of the gate voltage V_{GS} as may be taken from the timing chart 46. Furthermore, this causes a further charging of the inductor L₁16 until t₁₀ where the second transistor T₂ is shut off, the fourth transistor T₄ is switched on, the inductor current I_{L} reaches its peak and the gate voltage V_{GS} is down to ground. Then, after t₁₀, the inductor current I_{L} almost linearly drops to zero, as may be taken from the timing chart 44.

As a comparison of the time period [t₉; t₁₀] to the time period [t₃; t₄] of the timing chart 36 in Fig. 2 shows, the time period [t₉; t_{c}] is significantly shorter than the time period [t₃; t₄]. Thus the voltage drop of the voltage V_{GS} during [t₉; t₁₀] is significantly steeper than during [t₃; t₄].

As may be taken from Fig. 3, a very fast and efficient switching (off switching) may be achieved by providing an overlap time between the second switch T₂ and the third transistor T₃. By this, an inductor current I_{L} is built up during [t₈; t₉] prior to the switching action at t₉. Due to this a much higher initial current I_{L} charges the gate of the MOSFET 20, which allows for a much faster charging of the gate capacitors C_{GS} 18.

According to an aspect of the present invention, the pre-charging is performed such that the inductor current I_{L} reaches approximately half of its peak-value before the switching of the respective one of switches T₃ and T₄ controlling the switching of MOSFET 20.

Thus, as described above, a method of operating a resonant gate driver circuit for driving a MOSFET and a control circuit for controlling the switches of a resonant gate driver circuit according to exemplary embodiments of the present invention are provided, allowing for a combination of fast switching and very high efficiency. Advantageously, this may allow the application of resonant gate driver circuit in, for example, power electronics with MOSFETs which work with high switching frequencies. Those may, for example, advantageously be used in SMPS with special requirements, such as flatness, size EMI or dynamics. Exemplary application fields are, for example, VRMs for data processors, SMPS for flat displays or SMPS for audio sets.

Instead of MOSFETs as used in the above exemplary embodiments, the present invention is also applicable for almost all kinds of voltage controlled semiconductor switches such as IGBTs. Furthermore, the present invention may be applied to current controlled semiconductors such as bipolar transistors, thyristors and triacs.

## Claims

1. Method of operating a resonant driver circuit for driving a semiconductor switch, wherein the driver circuit includes a first switch for connecting a power supply via an inductor to a control terminal of the semiconductor switch and a second switch connected to the control terminal of the semiconductor switch for controlling a switching of the semiconductor switch, the method comprising the step of:
pre-charging the inductor before a switching of the second switch.

2. The method of claim 1, wherein the semiconductor switch is a voltage controlled switch wherein the inductor is pre-charged by building up an inductor current prior to the switching of the second switch.

3. The method of claim 2, wherein the inductor current is built up by providing a time period, during which the first switch and the second switch are switched on.

4. The method of claim 3, wherein the semiconductor switch has an input capacitance at its control terminal; and wherein the initial current allows for a fast switching of the semiconductor switch.

5. The method of claim 2, wherein the pre-charging is performed such that the inductor current reaches approximately half of its peak-value before the switching of the second switch.

6. The method of claim 1, wherein the driver circuit further comprises: a third switch arranged between a power supply voltage and a first end of the inductor; a fourth switch arranged between ground and the first end of the inductor; a fifth switch arranged between the power supply voltage and a second end of the inductor, wherein the second end of the inductor is connected to the gate of the MOSFET; a sixth switch arranged between ground and the second end of the inductor; wherein a capacitance is arranged between the second end of the inductor and ground; wherein, the first switch is one of the third and fourth switches; wherein, when the first switch is the third switch, the second switch is the sixth switch; and wherein, when the first switch is the fourth switch, the second switch is the fifth switch, such that, for switching the MOSFET on, the sixth switch is kept on for a first period of time after the third switch was switched on, and such that, for switching the MOSFET off, the fifth switch is kept on for a second period of time after the fourth switch was switched on.

7. The method of claim 1, wherein the semiconductor switch is a MOSFET.

8. A control circuit for operating a resonant driver circuit for driving a semiconductor switch, wherein the driver circuit includes a first switch for connecting a power supply via an inductor to a control terminal of the semiconductor switch and a second switch connected to the gate of the semiconductor switch for controlling a switching of the semiconductor switch, the control circuit comprising: a switch controller for controlling the switching of the first and second switches such that the inductor is pre-charged before a switching of the second switch.

9. The control circuit of claim 8, wherein the inductor is pre-charged by building up an inductor current previous to the on-switching of the second switch by controlling the switching of the first and second switches by the switch controller such that the second switch is switched on before the first switch is switched off.

## Patentansprüche

1. Verfahren zum Betrieb einer Resonanzsteuerschaltung zur Ansteuerung eines Halbleiterschalters, wobei die Treiberschaltung einen ersten Schalter, um eine Energieversorgung über einen Induktor mit einem Steueranschluss des Halbleiterschalters zu verbinden, und einen zweiten Schalter aufweist, welcher mit dem Steueranschluss des Halbleiterschalters verbunden ist, um ein Schalten des Halbleiterschalters zu steuern, wobei nach dem Verfahren der Induktor vor einem Schaltvorgang des zweiten Schalters voraufgeladen wird.

2. Verfahren nach Anspruch 1, wobei der Halbleiterschalter ein spannungsgesteuerter Schalter ist, wobei der Induktor durch Aufbau eines Induktorstroms vor dem Schaltvorgang des zweiten Schalters voraufgeladen wird.

3. Verfahren nach Anspruch 2, wobei der Induktorstrom aufgebaut wird, indem eine Zeitperiode vorgesehen wird, in welcher der erste Schalter und der zweite Schalter eingeschaltet werden.

4. Verfahren nach Anspruch 3, wobei der Halbleiterschalter eine Eingangskapazität an seinem Steueranschluss aufweist und wobei der Ausgangsstrom ein schnelles Schalten des Halbleiterschalters ermöglicht.

5. Verfahren nach Anspruch 2, wobei die Voraufladung so durchgeführt wird, dass der Induktorstrom vor dem Schaltvorgang des zweiten Schalters in etwa die Hälfte seines Spitzenwertes erreicht.

6. Verfahren nach Anspruch 1, wobei die Treiberschaltung weiterhin aufweist: einen dritten Schalter, welcher zwischen einer Speisespannung und einem ersten Ende des Induktors angeordnet ist, einen vierten Schalter, welcher zwischen Erde und dem ersten Ende des Induktors angeordnet ist, einen fünften Schalter, welcher zwischen der Speisespannung und einem zweiten Ende des Induktors angeordnet ist, wobei das zweite Ende des Induktors mit dem Gate des MOSFETs verbunden ist, einen sechsten Schalter, welcher zwischen Erde und dem zweiten Ende des Induktors angeordnet ist, wobei eine Kapazität zwischen dem zweiten Ende des Induktors und Erde vorgesehen ist, wobei der erste Schalter der dritte oder vierte Schalter ist, wobei, wenn der erste Schalter der dritte Schalter ist, der zweite Schalter der sechste Schalter ist, und wobei, wenn der erste Schalter der vierte Schalter ist, der zweite Schalter der fünfte Schalter ist, so dass zum Einschalten des MOSFETs der sechste Schalter während einer ersten Zeitperiode nach Einschalten des dritten Schalters eingeschaltet bleibt, und so dass zum Abschalten des MOSFETs der fünfte Schalter während einer zweiten Zeitperiode nach Einschalten des vierten Schalters eingeschaltet bleibt.

7. Verfahren nach Anspruch 1, wobei der Halbleiterschalter ein MOSFET ist.

8. Steuerschaltkreis zum Betrieb einer Resonanzsteuerschaltung zur Ansteuerung eines Halbleiterschalters, wobei die Treiberschaltung einen ersten Schalter, um eine Energieversorgung über einen Induktor mit einem Steueranschluss des Halbleiterschalters zu verbinden, und einen zweiten Schalter aufweist, welcher mit dem Gate des Halbleiterschalters verbunden ist, um ein Schalten des Halbleiterschalters zu steuern, wobei der Steuerschaltkreis einen Schaltregler aufweist, um den Schaltvorgang des ersten und zweiten Schalters so zu steuern, dass der Induktor vor einem Schaltvorgang des zweiten Schalters voraufgeladen wird.

9. Steuerschaltkreis nach Anspruch 8, wobei der Induktor vor dem Einschalten des zweiten Schalters durch Aufbau eines Induktorstroms voraufgeladen wird, indem der Schaltvorgang des ersten und zweiten Schalters durch den Schaltregler so gesteuert wird, dass der zweite Schalter vor Ausschalten des ersten Schalters eingeschaltet wird.

## Revendications

1. Procédé pour faire fonctionner un circuit d'attaque résonnant pour actionner un commutateur semi-conducteur dans lequel le circuit d'attaque comprend un premier commutateur pour connecter une alimentation en énergie, par le biais d'une inductance, à une borne de commande du commutateur semi-conducteur et un deuxième commutateur qui est connecté à la borne de commande du commutateur semi-conducteur pour commander une commutation du commutateur semi-conducteur, le procédé comprenant l'étape consistant à:
précharger l'inductance avant une commutation du deuxième commutateur.

2. Procédé selon la revendication 1, dans lequel le commutateur semi-conducteur est un commutateur commandé en tension où l'inductance est préchargée par l'accumulation d'un courant d'inductance avant la commutation du deuxième commutateur.

3. Procédé selon la revendication 2, dans lequel le courant d'inductance est accumulé par la fourniture d'une période de temps pendant laquelle le premier commutateur et le deuxième commutateur sont mis en circuit.

4. Procédé selon la revendication 3, dans lequel le commutateur semi-conducteur présente une capacité d'entrée à sa borne de commande et dans lequel le courant initial permet une commutation rapide du commutateur semi-conducteur.

5. Procédé selon la revendication 2, dans lequel la précharge est exécutée de telle façon que le courant d'inductance atteigne approximativement la moitié de sa valeur de crête avant la commutation du deuxième commutateur.

6. Procédé selon la revendication 1, dans lequel le circuit d'attaque comprend encore un troisième commutateur qui est agencé entre une tension d'alimentation en énergie et une première extrémité de l'inductance; un quatrième commutateur qui est agencé entre la masse et la première extrémité de l'inductance, un cinquième commutateur qui est agencé entre la tension d'alimentation en énergie et une deuxième extrémité de l'inductance dans lequel la deuxième extrémité de l'inductance est connectée à la grille du transistor MOSFET; un sixième commutateur qui est agencé entre la masse et la deuxième extrémité de l'inductance dans lequel une capacité est agencée entre la deuxième extrémité de l'inductance et la masse; dans lequel le premier commutateur est un des troisième et quatrième commutateurs; dans lequel, lorsque le premier commutateur est le troisième commutateur, le deuxième commutateur est le sixième commutateur; et dans lequel, lorsque le premier commutateur est le quatrième commutateur, le deuxième commutateur est le cinquième commutateur de telle façon que, pour la mise en circuit du transistor MOSFET, le sixième commutateur soit maintenu en circuit pendant une première période de temps après la mise en circuit du troisième commutateur et de telle façon que, pour la mise hors circuit du transistor MOSFET, le cinquième commutateur soit mis en circuit pendant une deuxième période de temps après la mise en circuit du quatrième commutateur.

7. Procédé selon la revendication 1, dans lequel le commutateur semi-conducteur est un transistor MOSFET.

8. Circuit de commande pour faire fonctionner un circuit d'attaque résonnant afin d'actionner un commutateur semi-conducteur dans lequel le circuit d'attaque comprend un premier commutateur pour connecter une alimentation en énergie, par le biais d'une inductance, à une borne de commande du commutateur semi-conducteur et un deuxième commutateur qui est connecté à la grille du commutateur semi-conducteur pour commander une commutation du commutateur semi-conducteur, le circuit de commande comprenant un contrôleur de commutateur pour commander la commutation des premier et deuxième commutateurs de telle façon que l'inductance soit préchargée avant une commutation du deuxième commutateur.

9. Circuit de commande selon la revendication 8, dans lequel l'inductance est préchargée par l'accumulation d'un courant d'inductance préalablement à la mise en circuit du deuxième commutateur par la commande de la commutation des premier et deuxième commutateurs par le contrôleur de commutateur de telle façon que le deuxième commutateur soit mis en circuit avant la mise hors circuit du premier commutateur.
